# EUROPEAN PATENT APPLICATION

(11) **EP 4 719 000 A1**
(43) Date of publication of application: **01.04.2026**
(21) Application number: 23943250.3
(22) Date of filing: 26.10.2023
(51) Int. Cl.: H10F 19/80, H10F 19/85, H10F 19/90

(54) **PHOTOVOLTAIC ASSEMBLY**

(30) Priority: 26.06.2023 CN 202310755421
(71) Applicant: Trina Solar Co., Ltd, Changzhou, Jiangsu 213031 (CN)
(72) Inventor: ZHANG, Shu, Xinbei District Changzhou, Jiangsu 213031 (CN); HUANG, Hongwei, Xinbei District Changzhou, Jiangsu 213031 (CN); WANG, Le, Xinbei District Changzhou, Jiangsu 213031 (CN)
(74) Representative: Arnold & Siedsma
(86) International application number: PCT/CN2023/126833
(87) International publication number: WO 2025/000771

(57) **Abstract**

A photovoltaic assembly, comprising: a back panel (100) and a front panel (200), which are arranged opposite each other; battery strings (300), which are arranged between the back panel (100) and the front panel (200); bus-bars (400), which are electrically connected to the battery strings (300); and waterproof structures (600), which are sandwiched between the back panel (100) and the front panel (200), wherein a lead hole (K) is provided in the back panel (100), each bus-bar (400) is provided with a lead-out end (401), and the lead-out end (401) is threaded through the lead hole (K) by means of a waterproof structure (600); and the orthographic projection of the lead hole (K) on a reference plane is located within an outer contour of the orthographic projections of the waterproof structures (600) on the reference plane, the reference plane being a plane parallel to the plane where the lead hole (K) is located.

## Description

### CROSS-REFERENCE TO RELATED APPLICATIONS

This application claims priority to Chinese patent application No. 202310755421.4, entitled "Photovoltaic Module", filed on June 26, 2023, the disclosure of which is incorporated herein by reference in its entirety.

### TECHNICAL FIELD

The present application relates to the technical field of photovoltaics, and in particular, to a photovoltaic module.

### BACKGROUND

In the related art, a back sheet of a photovoltaic module is provided with a lead hole for a busbar connected to a solar cell string to pass through, and the busbar passes through the lead hole and is then connected into a junction box. However, water and moisture easily enter the photovoltaic module through the lead hole to generate water and moisture erosion on the solar cell string, thereby affecting an output power of the photovoltaic module, and even posing potential safety hazards.

### SUMMARY

According to various embodiments of the present application, a photovoltaic module is provided.

Embodiments of the present application provide a photovoltaic module, including:
a back sheet and a front sheet which are oppositely arranged;
a solar cell string arranged between the back sheet and the front sheet;
a busbar electrically connected to the solar cell string; and
a waterproof structure sandwiched between the back sheet and the front sheet; the back sheet being provided with a lead hole, the busbar having a leading-out end, and the leading-out end extending out of the lead hole via the waterproof structure.

An orthographic projection of the lead hole on a reference plane is located within an outer contour of an orthographic projection of the waterproof structure on the reference plane, and the reference plane is a plane parallel to a plane where the lead hole is located.

In one of the embodiments, an inner contour of the orthographic projection of the waterproof structure on the reference plane is located outside the orthographic projection of the lead hole on the reference plane; alternatively,
an inner contour of the orthographic projection of the waterproof structure on the reference plane coincides with an outer contour of the orthographic projection of the lead hole on the reference plane; alternatively,
at least a part of an inner contour of the orthographic projection of the waterproof structure on the reference plane is located within the orthographic projection of the lead hole on the reference plane.

In one of the embodiments, the inner contour of the orthographic projection of the waterproof structure on the reference plane has a regular shape; alternatively
the inner contour of the orthographic projection of the waterproof structure on the reference plane has an irregular shape.

In one of the embodiments, the busbar has a bent portion located upstream of the leading-out end in a leading-out direction.

In the leading-out direction, the bent portion is located between the waterproof structure and the lead hole; alternatively,
the bent portion is located in the waterproof structure.

In one of the embodiments, the orthographic projection of the lead hole on the reference plane is located on the orthographic projection of the waterproof structure on the reference plane.

In one of the embodiments, the waterproof structure has an exposed surface exposed through the lead hole;
the leading-out end extends out of the exposed surface.

In one of the embodiments, an outer contour of the orthographic projection of the waterproof structure on the reference plane has a regular shape; alternatively
an outer contour of the orthographic projection of the waterproof structure on the reference plane has an irregular shape.

In one of the embodiments, the waterproof structure is made of rubber, a rubber mixture, silica gel, a silica gel mixture, silicone rubber, resin or a hybrid material, and the hybrid material includes at least one of rubber, a rubber mixture, silica gel, a silica gel mixture, silicone rubber and resin.

In one of the embodiments, the back sheet is a glass sheet, a metal composite sheet, a composite polymer sheet containing a metal film layer, or a composite polymer sheet containing an inorganic non-metal film layer.

In one of the embodiments, the photovoltaic module further includes a packaging adhesive film;
the solar cell string is packaged in the packaging adhesive film, and the packaging adhesive film is bonded between the back sheet and the front sheet.

Details of one or more embodiments of the present application are set forth in the accompanying drawings and the description below. Other features, objects, and advantages of the present application will be apparent from the description, the drawings, and the claims.

### BRIEF DESCRIPTION OF THE DRAWINGS

In order to illustrate the technical solutions in embodiments of the present application or the related art more clearly, the drawings required for describing the embodiments or the related art will be described briefly. Apparently, the following described drawings are merely for embodiments of the present application, and other drawings can be derived from the disclosed drawings by those of ordinary skill in the art without any creative effort.
FIG. 1 is a schematic structural view of a photovoltaic module according to an embodiment of the related art.
FIG. 2 is a schematic sectional view of a partially enlarged sectional structure taken in a direction A-A in the photovoltaic module illustrated in FIG. 1.
FIG. 3 is a schematic top view of the partially enlarged sectional structure illustrated in FIG. 2.
FIG. 4 is a schematic sectional structural view of a photovoltaic module according to another embodiment of the related art.
FIG. 5 is a schematic structural view of a photovoltaic module according to some embodiments of the present application.
FIG. 6 is a schematic view of a partially enlarged structure of the photovoltaic module illustrated in FIG. 5.
FIG. 7 is a schematic view of a partially enlarged sectional structure taken in a direction B-B in the photovoltaic module illustrated in FIG. 5 in an implementation.
FIG. 8 is a schematic top view of the partially enlarged sectional structure illustrated in FIG. 7.
FIG. 9 is a schematic view of the partially enlarged sectional structure taken in the direction B-B in the photovoltaic module illustrated in FIG. 5 in another implementation.
FIG. 10 is a schematic top view of the partially enlarged sectional structure illustrated in FIG. 9.
FIG. 11 is a schematic view of the partially enlarged sectional structure taken in the direction B-B in the photovoltaic module illustrated in FIG. 5 in yet another implementation.
FIG. 12 is a schematic top view of the partially enlarged sectional structure illustrated in FIG. 11.
FIG. 13 is a schematic view of the partially enlarged sectional structure taken in direction B-B in the photovoltaic module illustrated in FIG. 5 in still another implementation.
FIG. 14 is a schematic top view of the partially enlarged sectional structure illustrated in FIG. 13.
FIG. 15 is a schematic view of a partially enlarged structure of the photovoltaic module illustrated in FIG. 5 in an implementation.
FIG. 16 is a schematic view of the partially enlarged structure of the photovoltaic module illustrated in FIG. 5 in another implementation.
FIG. 17 is a schematic view of the partially enlarged structure of the photovoltaic module illustrated in FIG. 5 in yet another implementation.
FIG. 18 is a schematic view of the partially enlarged structure of the photovoltaic module illustrated in FIG. 5 in still another implementation.

Illustration for reference signs:
Back sheet 10; lead hole k;
front sheet 20;
solar cell string 30;
busbar 40; leading-out end 41;
packaging adhesive film 50;
waterproof structure 60;
back sheet 100; lead hole K;
front sheet 200;
solar cell string 300;
busbar 400; leading-out end 401; bent portion 402;
packaging adhesive film 500; first adhesive film layer 510; second adhesive film layer 520;
waterproof structure 600; exposed surface m; size d;
interconnecting ribbon L;
first direction F1; second direction F2.

### DETAILED DESCRIPTION

The technical solutions in embodiments of the present application are clearly and completely described below with reference to the accompanying drawings in the embodiments of the present application, and apparently, the described embodiments are only a part of the embodiments of the present application, and not all of the amendments. All other embodiments obtained by a person of ordinary skill in the art based on embodiments of the present application without creative efforts shall fall within the protection scope of the present application.

In the description of the present application, it should be understood that the orientation or position relationship indicated by the terms "central", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", etc. are based on the orientation or position relationship shown in the accompanying drawings, and are only intended to facilitate the description of the present application and simplify the description, rather than indicating or implying that the device or element referred to must have a particular orientation or be constructed and operated in a particular orientation, and therefore are not to be interpreted as limitations on the present application.

In addition, if terms "first" and "second" appear, the terms are used for purposes of description and shall not be construed as indicating or implying a relative importance, or implicitly specifying the number of the indicated technical features. Thus, the feature defined by "first" and "second" may include at least one of the features explicitly or implicitly. In the description of the present application, "a plurality of", "multiple" means at least two, such as two, three, or the like, unless otherwise explicitly specified.

In the present application, unless specifically stated and limited, if the terms "mounting," "coupling", "connecting" and "fixing" appear, they should be understood in a broad sense. They may be, for example, a fixed connection, a detachable connection, or an integral connection; or a mechanical connection or an electrical connection; or a direct connection, an indirect connection through an intermediate medium, or an internal connection of two elements, or an interaction of two elements, unless otherwise specified. It should be noted that in the following description and the appended claims, the term "electrically connected" between one feature and another feature includes not only the one feature being in direct contact with the other feature to form a power transmission or current transfer channel, but also an intermediate feature between the one feature and the other feature, where the one feature, the other feature, and the intermediate feature therebetween form a power transmission or current transfer channel to realize power transmission or transfer. For those of ordinary skill in the art, the specific meanings of the above terms in the present application can be understood on case-by-case.

In the present application, unless otherwise clearly specified and limited, if there is a description that a first feature is "above" or "below" a second feature, etc., or similar descriptions appear, it may mean that the first and second features are in direct contact, or that the first and second features are in indirect contact through an intermediate medium. Moreover, the first feature being "above", "on" and "on top of" the second feature may mean that the first feature is directly above or obliquely above the second feature, or simply means that the first feature is higher in level than the second feature. The first feature being "below", "beneath" and "under" the second feature may mean that the first feature is directly below or obliquely below the second feature, or simply means that the first feature is lower in level than the second feature.

It should be noted that if an element is referred to as being "fixed to" or "disposed on" another element, it may be directly on the other element or there may be an intermediate element. If an element is considered to be "connected to" another element, it may be directly connected to the other element or there may be an intermediate element at the same time. If any, the terms "vertical", "horizontal", "upper", "lower", "left", "right" and similar expressions used in this application are for illustrative purposes only and do not represent the only implementation.

With a development of a photovoltaic module industry, various high efficiency solar cells emerge, such as a hereto-junction with intrinsic thin-layer (HJT) cell, a tunnel oxide passivating contact (TopCon) cell, a perovskite cell and a tandem cell. Although the high efficiency solar cell has a higher photoelectric conversion efficiency, electrical and optical structures become more sensitive to environmental factors. In order to prevent water and moisture in an external environment from permeating into a photovoltaic module, higher requirements are put forward for a water blocking performance of a packaging structure of the photovoltaic module.

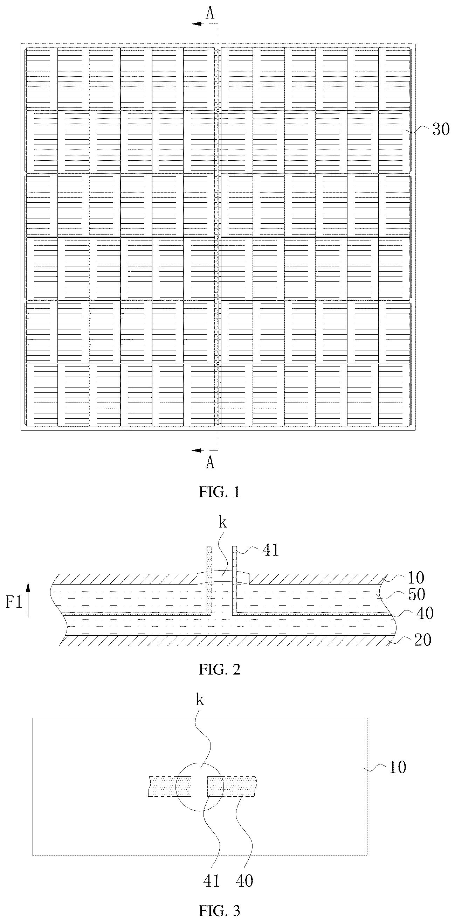

FIG. 1 shows a schematic structural view of a photovoltaic module according to an embodiment of the related art. FIG. 2 shows a schematic view of a partially enlarged sectional structure taken in a direction A-A in the photovoltaic module illustrated in FIG. 1. FIG. 3 shows a schematic top view of the partially enlarged sectional structure illustrated in FIG. 2. For convenience of illustration, only contents related to embodiments of the related art are shown.

Referring to FIG. 1 to FIG. 3, an embodiment of the related art provides a photovoltaic module, including a back sheet 10, a front sheet 20, a solar cell string 30, a busbar 40, and a packaging adhesive film 50. The back sheet 10 and the front sheet 20 are arranged oppositely, and the solar cell string 30 is arranged between the back sheet 10 and the front sheet 20. As an example, the solar cell string 30 is packaged in the packaging adhesive film 50, and the packaging adhesive film 50 is bonded between the back sheet 10 and the front sheet 20. As shown in FIG. 2 and FIG. 3, the back sheet 10 is provided with a lead hole k. The busbar 40 is electrically connected to the solar cell string 30. A leading-out end 41 of the busbar 40 extends out of the lead hole k and is connected into a junction box (not shown in the drawings). It can be seen that, as shown in FIG. 2, if there is water and moisture outside the lead hole k, the water and moisture may enter the photovoltaic module through the lead hole k to generate water and moisture erosion on the solar cell string 30, thereby affecting an output power of the photovoltaic module, and even posing potential safety hazards.

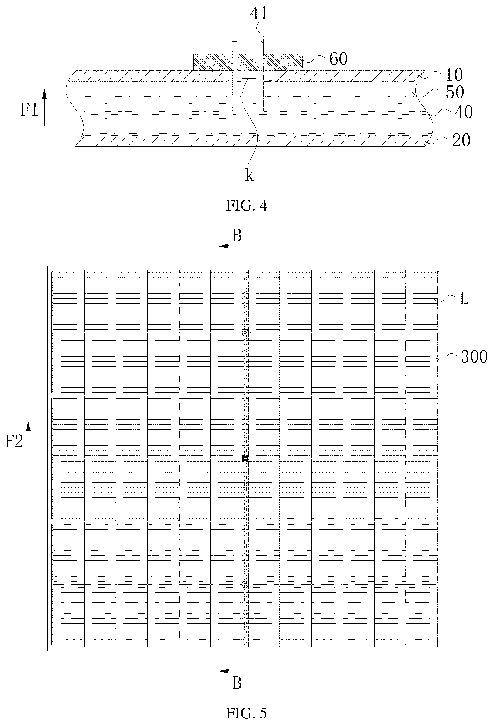

Referring to FIG. 2 together, since the lead hole k is formed in a first direction F1, the water and moisture may roughly enter the photovoltaic module through the lead hole k in the first direction F1. As shown in FIG. 4 which shows a schematic sectional structural view of the photovoltaic module according to another embodiment of the related art, due to a small thickness of the photovoltaic module in the first direction F1, the inventors of the present application have tried to provide a waterproof structure 60 outside the photovoltaic module, the waterproof structure 60 covering the lead hole k in the first direction F1. Thus, the water and moisture can be prevented from entering the photovoltaic module in the first direction F1, and a waterproof capability at the lead hole k is improved.

However, the inventors of the present application found that if the waterproof structure 60 is arranged outside the photovoltaic module, that is, outside the back sheet 10, and located near the lead hole k, when the photovoltaic module is subjected to an external stress, the waterproof structure 60 arranged outside the photovoltaic module may be detached, be displaced, or even fall from the back sheet 10, resulting in a failure of the waterproof structure 60. For example, after lamination of the photovoltaic module, the photovoltaic module is at a high temperature higher than 140°C, adhesion ability on an outer side surface of the back sheet 10 is quite low, and in subsequent processes, the waterproof structure 60 may generate the failure as described above due to the external stress caused by shaking of an assembly line and subsequent cleaning, transportation, and turning. As another example, since the leading-out end 41 of the busbar 40 extends out of the lead hole k, the leading-out end 41 of the busbar 40 is a free end, may be affected by the external stress, and then transfers the external stress to the waterproof structure 60, so that delamination between the busbar 40 and the waterproof structure 60 is caused, and a water and moisture permeation channel is formed, thus further weakening a waterproof effect. If a related fixing structure is additionally disposed to improve stability of the waterproof structure 60 arranged outside the photovoltaic module, the structure outside the photovoltaic module becomes more complicated, which also can affect a subsequent mounting process of the photovoltaic module. In addition, even if the related fixing structure exists, the related fixing structure still faces the risk of being subjected to the external stress, reliability and a related arrangement of the related fixing structure are required to be further considered, and thus, it is also difficult to obtain a required waterproof effect.

After in-depth study, the inventors of the present application found that, in general, a certain pressure may be applied to the photovoltaic module by a relevant device such as a solar photovoltaic laminating machine, so as to tightly press the photovoltaic module into a whole in a heating state. That is, a certain interlayer pressure may be formed in the photovoltaic module. Therefore, in order to improve the above-mentioned situation that the external stress causes the waterproof failure and the related complicated waterproof structure, the inventors of the present application have tried to arrange the waterproof structure inside the photovoltaic module and use the interlayer pressure to improve reliability of the waterproof structure, so as to improve the situation that the water and moisture enters the photovoltaic module through the lead hole, reduce the impact on the output power of the photovoltaic module, and improve a safety performance.

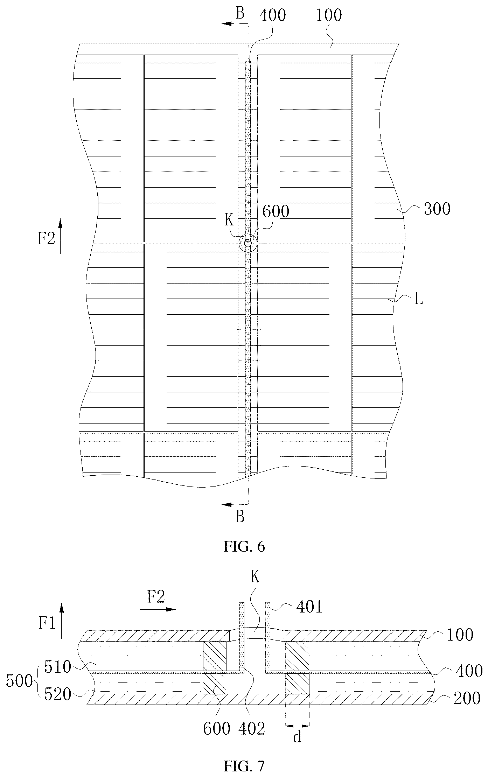

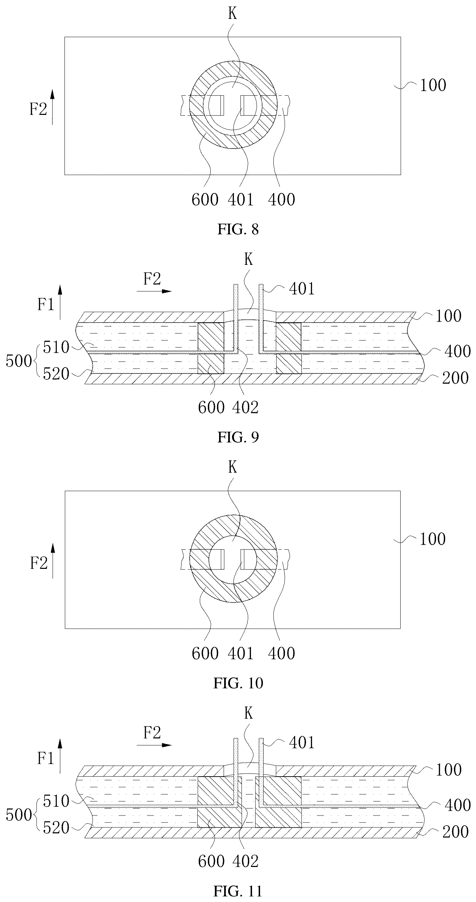

FIG. 5 shows a schematic structural view of a photovoltaic module according to some embodiments of the present application. FIG. 6 shows a schematic view of a partially enlarged structure of the photovoltaic module illustrated in FIG. 5. FIG. 7 shows a schematic view of a partially enlarged sectional structure taken in a direction B-B in the photovoltaic module illustrated in FIG. 5 in an implementation. FIG. 8 shows a schematic top view of the partially enlarged sectional structure illustrated in FIG. 7. For convenience of illustration, only contents related to embodiments of the present application are shown.

In some embodiments, referring to FIG. 5 to FIG. 7, the photovoltaic module according to embodiments of the present application includes a back sheet 100, a front sheet 200, a solar cell string 300, a busbar 400, a packaging adhesive film 500, and a waterproof structure 600.

The back sheet 100 and the front sheet 200 are oppositely arranged. That is, in a first direction F1 illustrated in FIG. 7, the back sheet 100 and the front sheet 200 are oppositely arranged. The first direction F1 is a thickness direction of the photovoltaic module. The front sheet 200 refers to a sheet that faces the sunlight when the photovoltaic module normally works. Correspondingly, the back sheet 100 refers to a sheet that faces away from the sunlight when the photovoltaic module normally works. The front sheet 200 may be a glass sheet, and the back sheet 100 may be a glass sheet, a metal composite sheet, a composite polymer sheet containing a metal film layer, a composite polymer sheet containing an inorganic non-metal film layer, a polymer sheet, or the like. The glass sheet is a sheet-like member made of glass. The metal composite sheet is a sheet-like member made of a metal composite material formed by different metals, and for example, the metal composite sheet may be an aluminum-containing composite sheet. The composite polymer sheet containing the metal film layer is a sheet-like member containing the metal film layer. The composite polymer sheet containing the inorganic non-metal film layer is a sheet-like member containing the inorganic non-metal film layer. The polymer sheet can be a polyethylene terephthalate (PET) sheet, a composite material sheet of PET, a fluorine-containing material sheet and a composite material sheet of a fluorine-containing material. In the case where the back sheet contains the metal film layer or the inorganic non-metal film layer, innermost and outermost layers of the back sheet may be polymer film layers, and an intermediate layer of the back sheet may be the metal film layer or the inorganic non-metal film layer. The polymer film layer can play an insulating role, and the metal film layer or the inorganic non-metal film layer can further improve a water and moisture blocking capability.

It can be understood that the back sheet 100 has a more excellent water and moisture blocking capability in the case where the back sheet 100 is the glass sheet, the metal composite sheet, the composite polymer sheet containing the metal film layer, or the composite polymer sheet containing the inorganic non-metal film layer. As an example, the front sheet 200 and the back sheet 100 may be glass sheets, and the photovoltaic module is a dual glass module, which may further improve the water and moisture blocking capability of the back sheet 100.

As shown in FIG. 7 and FIG. 8, the back sheet 100 is provided with a lead hole K. The lead hole K is configured for providing a channel through which a relevant wiring extends out of the photovoltaic module.

The solar cell string 300 is arranged between the back sheet 100 and the front sheet 200. The solar cell string 300 includes a plurality of solar cells. As an example, the solar cells in the solar cell string 300 may be connected to each other in such a way that a front electrode of one solar cell is electrically connected to a back electrode of the adjacent solar cell by an interconnecting ribbon L, and connection between the solar cells of the same solar cell string 300 may be realized by the interconnecting ribbon L. A specific connection structure for the solar cell string 300 may be set according to actual use conditions, and is not limited in the embodiments of the present application.

The busbar 400 is electrically connected to the solar cell string 300. For example, the adjacent solar cell strings 300 are connected to each other by connecting the busbar 400 to tails of the interconnecting ribbons L arranged on the solar cells at head and tail ends of the solar cell strings 300. Taking FIG. 5 and FIG. 6 as an example, the busbars 400 are arranged at end portions and the middle portion of the photovoltaic module respectively. In the embodiments of the present application, the busbar 400 located at the middle portion of the photovoltaic module has a leading-out end 401.

The packaging adhesive film 500 is a member configured for packaging the solar cell string 300. The packaging adhesive film 500 may provide mechanical buffer protection for the solar cell string 300, and is configured to provide a supporting force between the back sheet 100 and the front sheet 200 to the waterproof structure 600. The packaging adhesive film 500 may be an ethylene vinyl acetate copolymer film (EVA film), a polyvinyl butyral film (PVB film), a thermoplastic polyurethane film (TPU film), a polydimethylsiloxane film (PDMS film), a polyolefin elastomer film (POE film), an ionomer ethylene copolymer film, or the like. The packaging adhesive film 500 may include a first adhesive film layer 510 and a second adhesive film layer 520. The solar cell string 300 is packaged between the first adhesive film layer 510 and the second adhesive film layer 520. The first adhesive film layer 510 is bonded to the back sheet 100, and the second adhesive film layer 520 is bonded to the front sheet 200. A material for the packaging adhesive film 500 can be selected according to actual use conditions, and is not limited in the embodiments of the present application.

The waterproof structure 600 is a member having a certain water blocking capability. The waterproof structure 600 is sandwiched between the back sheet 100 and the front sheet 200. That is, the waterproof structure 600 may be sandwiched between the back sheet 100 and the front sheet 200 by oppositely arranging the front sheet 200 and the back sheet 100. The leading-out end 401 of the busbar 400 extends out of the lead hole K through the waterproof structure 600. That is, the leading-out end 401 of the busbar 400 can extend out of the waterproof structure 600 before extending out of the lead hole K. It can be understood that the lead hole K corresponds to the leading-out end 401 of the busbar 400. For example, as shown in FIG. 6, the busbar 400 at the middle portion of the photovoltaic module is illustrated to have the leading-out end 401 in the embodiments of the present application, and correspondingly, the lead hole K may be arranged at the middle portion of the photovoltaic module.

An orthographic projection of the lead hole K on a reference plane is located within an outer contour of an orthographic projection of the waterproof structure 600 on the reference plane, and the reference plane is a plane parallel to a plane where the lead hole K is located. That is, it can be roughly considered that the lead hole K is surrounded by the waterproof structure 600. The configurations of the waterproof structure 600 and the lead hole K are not limited in the embodiments of the present application as long as the orthographic projection of the lead hole K on the reference plane is located within the outer contour of the orthographic projection of the waterproof structure 600 on the reference plane.

Thus, in the case where the waterproof structure 600 is arranged inside the photovoltaic module, after the photovoltaic module is laminated, since the adhesive film 500 has adhesion ability, bonding force between the waterproof structure 600 and the back sheet 100 and between the waterproof structure 600 and the front sheet 200 is more secure, and the above-mentioned situation of the waterproof failure caused by detachment of an interface can be improved. Meanwhile, the whole structure is simple, compared with the manner of additionally providing the fixing structure. In addition, after the photovoltaic module is laminated, the busbar 400 located inside can be further fixed by means of the waterproof structure 600, so that the aforementioned delamination between the busbar 400 and the waterproof structure 600 due to the leading-out end 401 of the busbar 400 can be improved. In the case where the lead hole K is surrounded by the waterproof structure 600, when the water and moisture enter the photovoltaic module through the lead hole K, the water and moisture can be blocked by the waterproof structure 600, and then, the situation that the water and moisture enter the photovoltaic module through the lead hole K can be improved.

Effectiveness of the waterproof structure 600 will be described below in conjunction with the above-described structures illustrated in the embodiments of the present application and related comparative examples.

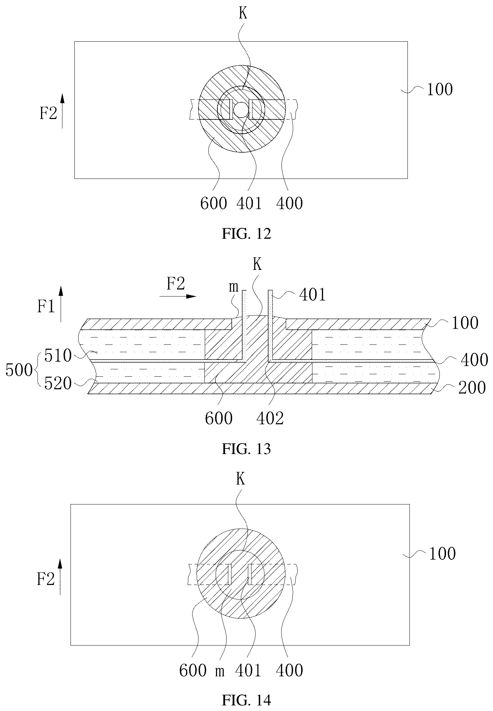

Taking the photovoltaic module illustrated in FIG. 7 as an example, the waterproof structure 600 in FIG. 7 is configured to be filled in the lead hole K to form the waterproof structure 600 shown in FIG. 12 and FIG. 13 as illustrated later; the structure illustrated in FIG. 13 is taken as an example of the present application (referred to as Group 1), the photovoltaic module illustrated in FIG. 2 is taken as a first comparative example (referred to as Group 2), and the photovoltaic module which is illustrated in FIG. 13 and does not include the busbar 400 is taken as a second comparative example (referred to as Group 3). In Group 1 and Group 3, the first adhesive film layer 510 and the second adhesive film layer 520 both were EVA films; and in Group 2, the packaging adhesive film 50 also included two adhesive films (i.e., a front adhesive film and a back adhesive film which were not denoted in the drawings), and the packaging adhesive film 50 was a POE film. In Group 1 and Group 3, referring to FIG. 7 together, sizes d of the waterproof structures in a second direction F2 perpendicular to the first direction F1 were set to about 6 mm. Cobalt oxide test papers were arranged in regions of the lead holes and edges of the solar cell strings corresponding to Group 1 to Group 3, and waterproof effectiveness was obtained by comparing colors of the cobalt oxide test papers.

The photovoltaic modules in Group 1, Group 2 and Group 3 are boiled in water at a heating temperature of 100°C for a heating time of 96 hours. It can be seen that in Group 1 and Group 3, the colors of the cobalt oxide test papers at the regions of the lead holes K do not change, and the colors of the cobalt oxide test papers at the edges of the solar cell strings also do not change. In Group 2, the color of the cobalt oxide test paper changes due to the water and moisture permeating from the lead hole k, with a color change range extending to a position about 15 mm away from the edge of the solar cell.

It should be noted that it can be learnt that a water permeability of the EVA film is approximately 30g/(m²·24h) and a water permeability of the POE film is approximately 4g/(m²·24h) at an ambient temperature of 38°C. That is, a waterproof performance of the EVA film is weaker than that of the POE film.

In the above experiment results, under the condition that the waterproof performances of the packaging adhesive films 500 of Group 1 and Group 3 are weaker than that of the packaging adhesive film 50 of Group 2, the waterproof structures 600 of Group 1 and Group 3 can still effectively block the permeation of the water and moisture. Meanwhile, a difference between Group 1 and Group 3 lies in the presence or absence of the busbar 400. That is, Group 1 is the structure provided by the embodiments of the present application, that is, in the waterproof structure 600, the busbar 400 passes through the waterproof structure 600 and reaches the exterior of the lead hole K, and in the Group 3, on the basis of the structure of Group 1, in the waterproof structure 600, no busbar 400 passes through the waterproof structure 600 and reaches the exterior of the lead hole K. However, the waterproof structures 600 of Group 1 and Group 3 are arranged at the same position. This further shows that a path in which the water and moisture penetrates through the lead hole K to the solar cell string 300 mainly passes through the back sheet 100 and a contact surface between the waterproof structure 600 and the back sheet 100, and a path in which the busbar 400 extends out of the waterproof structure 600 is not a main path for water and moisture to penetrate. In other words, in the embodiments of the present application, the waterproof structure 600 is arranged inside the photovoltaic module and the busbar 400 extends out of the waterproof structure 600, which does not additionally increase the water and moisture penetration path, so that the waterproof effect is not weakened. Certainly, in order to further improve the waterproof effect, a water and moisture permeation distance along an interface between a surface of the busbar 400 and the waterproof structure 600 can be increased by increasing roughness of the surface of the busbar 400 or adding some microstructures.

Based on the above experimental results, the inventors of the present application performed further study and found that, when the waterproof structure 600 is arranged inside the photovoltaic module, the water and moisture penetration distance can be increased compared to the case where the waterproof structure 600 is arranged outside the photovoltaic module, so that the water blocking capability of the waterproof structure 600 in the embodiments of the present application can be more excellent.

In conjunction with the above description, if the waterproof structure 600 is located outside the photovoltaic module, the waterproof structure 600 waterproofs the photovoltaic module in the first direction F1, so that it may be difficult to set a size of the waterproof structure 600 in the first direction F1 to be larger due to a limited space and a thickness limitation of the back sheet 100. For example, when a thickness of the back sheet 100 is 1.6 mm or 2 mm, if the waterproof structure 600 is arranged at the lead hole K, a limit value of the waterproof structure 600 is the thickness (1.6 mm or 2 mm) of the back sheet 100. In the embodiments of the present application, taking FIG. 7 as an example, the waterproof structure 600 can not only block water in the first direction F1, but also block water in the second direction F2, which can add an additional water blocking path compared to the manner of arranging the waterproof structure 600 outside the photovoltaic module. Since an internal space of the photovoltaic module near the lead hole K can be utilized, the size *d* of the waterproof structure 600 in the second direction F2 can be set to be larger (for example, the size d can be more than 6 mm and is greater than the thickness of the back sheet 100 as described above).

While not wishing to be constrained by theories, the inventors of the present application continued in-depth study and found that the following relationship exists between a water and moisture through-flow time t₀ when the waterproof structure 600 is arranged at the lead hole K and a water and moisture through-flow time t₁ when the waterproof structure 600 is arranged inside the photovoltaic module: t₁=(d₁/d₀)2t=9t₀. D₀ is the thickness of the back sheet 100 and d₁ is the size *d* of the waterproof structure 600. That is, the water and moisture through-flow time t₀ when the waterproof structure 600 is arranged at the lead hole K is less than the water and moisture through-flow time t₁ when the waterproof structure 600 is arranged inside the photovoltaic module. When the thickness of the back sheet 100 is 2 mm and the size *d* is 6 mm, t₁= (6/2)²t₀=9t₀. Thus, the arrangement of the waterproof structure 600 in the embodiments of the present application can prolong the water and moisture through-flow time, so that the water and moisture penetration distance is longer, and obviously, a more excellent water blocking capability is realized.

Therefore, the waterproof structure 600 arranged inside the photovoltaic module may not reduce the risk of the failure of the waterproof structure 600 cause by the waterproof structure 600 being arranged outside the photovoltaic module and easily subjected to the external stress, and also, can rigidly constraining the waterproof structure 600 by means of the lamination pressure of the photovoltaic module, so that the waterproof structure 600 is more firmly connected to the back sheet 100 and the front sheet 200. Meanwhile, compared to the manner that the waterproof structure 600 is arranged outside the photovoltaic module, the additional and longer water blocking path is added.

Thus, the arrangement of the waterproof structure 600 in the embodiments of the present application may improve the waterproof capability at the lead hole K, as well as improve the reliability of the waterproof structure 600, thereby reducing the impact on the output power of the photovoltaic module, and improving the safety performance.

In some embodiments, the orthographic projection of the waterproof structure 600 on the reference plane has an inner contour. That is, the waterproof structure 600 can be regarded as a hollow structure, and the waterproof structure 600 has an inner diameter. The waterproof structure 600 may be of a regular structure such as a revolution body structure. The waterproof structure 600 may alternatively be of an irregular structure such as a radial structure. Selection may be made according to the structural arrangement inside the photovoltaic module, and is not limited in the embodiments of the present application.

In some specific embodiments, the inner contour of the orthographic projection of the waterproof structure 600 on the reference plane is located outside the orthographic projection of the lead hole K on the reference plane. That is, as shown in FIG. 7 and FIG. 8, when looking down at the lead hole K of the back sheet 100, the waterproof structure 600 is not exposed in the lead hole K, and a minimum inner diameter of the waterproof structure 600 is greater than a maximum hole size of the lead hole K.

FIG. 9 shows a schematic view of a partially enlarged sectional structure taken in a direction B-B in the photovoltaic module illustrated in FIG. 5 in another implementation. FIG. 10 is a schematic top view of the partially enlarged sectional structure illustrated in FIG. 9. For convenience of illustration, only contents related to the embodiments of the present application are shown.

In some embodiments, the inner contour of the orthographic projection of the waterproof structure 600 on the reference plane coincides with an outer contour of the orthographic projection of the lead hole K on the reference plane. That is, as shown in FIG. 9 and FIG. 10, when looking down at the lead hole K of the back sheet 100, the waterproof structure 600 is not exposed in the lead hole K, and a contour of a hollow part of the waterproof structure 600 coincides with a contour of the lead hole K.

FIG. 11 shows a schematic view of the partially enlarged sectional structure taken in the direction B-B in the photovoltaic module illustrated in FIG. 5 in yet another implementation. FIG. 12 is a schematic top view of the partially enlarged sectional structure illustrated in FIG. 11. For convenience of illustration, only contents related to the embodiments of the present application are shown.

In some specific embodiments, at least a part of the inner contour of the orthographic projection of the waterproof structure 600 on the reference plane is located within the orthographic projection of the lead hole K on the reference plane. That is, when looking down at the lead hole K of the back sheet 100, the waterproof structure 600 is partially exposed in the lead hole K. The inner contour of the orthographic projection of the waterproof structure 600 on the reference plane may be completely located within the orthographic projection of the lead hole K on the reference plane, or may be partially located within the orthographic projection of the lead hole K on the reference plane, and partially located within the orthographic projection of the lead hole K on the reference plane. Taking FIG. 11 and FIG. 12 as an example, it is illustrated that the inner contour of the orthographic projection of the waterproof structure 600 on the reference plane may be completely located within the orthographic projection of the lead hole K on the reference plane, that is, when looking down at the lead hole K of the back sheet 100, the hollow part of the waterproof structure 600 is completely exposed in the lead hole K.

Thus, the required waterproof structure 600 may be flexibly arranged according to the implementations in some of the embodiments as described above.

In some embodiments, the busbar 400 has a bent portion 402 located upstream of the leading-out end 401 of the busbar 400 in a leading-out direction. In the leading-out direction, the bent portion 402 is located between the waterproof structure 600 and the lead hole K. Alternatively, the bent portion 402 is located within the waterproof structure 600. The leading-out direction refers to an extending direction of the busbar 400 towards the leading-out end 401. Taking FIG. 7, FIG. 8, FIG. 9 and FIG. 10 as an example, the situations that the bent portion 402 is located between the waterproof structure 600 and the lead hole K in the leading-out direction are illustrated. Taking FIG. 11 and FIG. 12 as an example, the situations that the bent portion 402 is located within the waterproof structure 600 is illustrated. It can be understood that in the case where the bent portion 402 is located within the waterproof structure 600, firmness of the busbar 400 located inside is higher. It can be arranged according to specific use situations, and is not limited in the embodiments of the present application.

FIG. 13 shows a schematic view of the partially enlarged sectional structure taken in the direction B-B in the photovoltaic module illustrated in FIG. 5 in still another implementation. FIG. 14 is a schematic top view of the partially enlarged sectional structure illustrated in FIG. 13. For convenience of illustration, only contents related to the embodiments of the present application are shown.

In some embodiments, referring to FIG. 13 and FIG. 14, the orthographic projection of the lead hole K on the reference plane is located on the orthographic projection of the waterproof structure 600 on the reference plane. That is, the orthographic projection of the waterproof structure 600 on the reference plane may have the outer contour and does not have the inner contour, alternatively, the orthographic projection of the waterproof structure 600 on the reference plane may have the inner contour, and the outer contour of the orthographic projection of the lead hole K on the reference plane and the inner contour of the orthographic projection of the waterproof structure 600 on the reference plane are independent from each other and do not overlap each other. FIG. 13 and FIG. 14 illustrate the situation where the orthographic projection of the waterproof structure 600 on the reference plane has the outer contour and does not have the inner contour. In other words, the lead hole K is filled with the waterproof structure 600, and the lead hole K is sealed, so that when the water and moisture is to enter the photovoltaic module, the water and moisture is first blocked by the waterproof structure 600 at the lead hole K. Thus, the water blocking capability of the waterproof structure 600 is further improved.

Certainly, it is also possible to fill the hollow part of the waterproof structure 600 with a sealing portion to form a situation illustrated in FIG. 13 on the basis of the waterproof structure 600 illustrated in FIG. 7. The sealing portion may extend from the interior of the photovoltaic module to the inside of the lead hole K. A material for the sealing portion may be the same as or different from that of the waterproof structure 600 as long as the material has a water blocking capability, and the material may be arranged according to specific use conditions and is not limited in the embodiments of the present application. Correspondingly, the leading-out end 401 of the busbar 400 may extend through the waterproof structure 600, the sealing portion, and the lead hole K in sequence, and then out of the back sheet 100.

In some embodiments, with continued reference to FIG. 13 and FIG. 14, the waterproof structure 600 has an exposed surface m exposed through the lead hole K, and the leading-out end 401 of the busbar 400 extends out of the exposed surface *m*. That is, parts of the busbar 400 located inside the photovoltaic module near the lead hole K are all fixed inside the waterproof structure 600. Thus, the firmness of the busbar 400 can be further improved.

In some embodiments, the outer contour of the orthographic projection of the waterproof structure 600 on the reference plane has a regular shape, and the regular shape may be a circle, a triangle, a rectangle, an ellipse, a trapezoid, or the like. Alternatively, the outer contour of the orthographic projection of the waterproof structure 600 on the reference plane has an irregular shape, and the irregular shape may include various shapes formed by straight lines or curved lines. A shape of the lead hole K may be regular or irregular. In some embodiments, when the orthographic projection of the waterproof structure 600 on the reference plane has the inner contour, the inner contour of the orthographic projection of the waterproof structure 600 on the reference plane has a regular shape. Alternatively, the inner contour of the orthographic projection of the waterproof structure 600 on the reference plane has an irregular shape. Reference may also be made to the related descriptions in some foregoing embodiments for the regular shapes and the irregular shapes, which are not repeated herein.

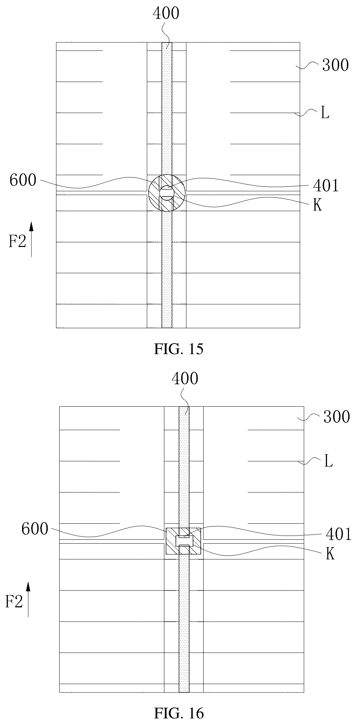

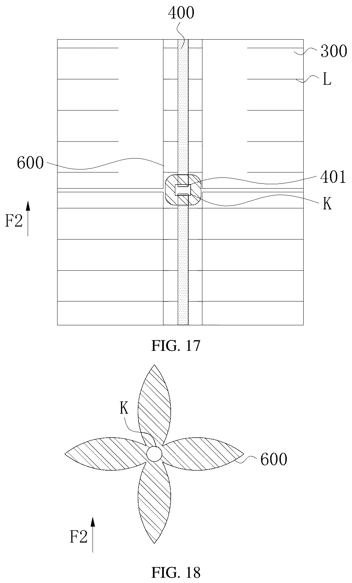

FIG. 16 shows a schematic view of the partially enlarged structure of the photovoltaic module illustrated in FIG. 5 in another implementation. FIG. 17 shows a schematic view of the partially enlarged structure of the photovoltaic module illustrated in FIG. 5 in yet another implementation. FIG. 18 shows a schematic view of the partially enlarged structure of the photovoltaic module illustrated in FIG. 5 in still another implementation. For convenience of illustration, only contents related to the embodiments of the present application are shown.

As an example, in the structures of the waterproof structure 600 and the lead hole K illustrated in FIG. 7 to FIG. 15, the outer contour and the inner contour of the orthographic projection of the waterproof structure 600 on the reference plane are circular, and the lead hole K is also circular. In the structures of the waterproof structure 600 and the lead hole K illustrated in FIG. 16, the outer contour and the inner contour of the orthographic projection of the waterproof structure 600 on the reference plane are rectangular, and the lead hole K is also rectangular. In the structures of the waterproof structure 600 and the lead hole K illustrated in FIG. 17, the outer contour and the inner contour of the orthographic projection of the waterproof structure 600 on the reference plane and the shape of the lead hole K are rectangles with four chamfered corners. In the structures of the waterproof structure 600 and the lead hole K illustrated in FIG. 18, only the waterproof structure 600 and the lead hole K are illustrated, the waterproof structure 600 is radial, and the lead hole K is circular.

In some embodiments, the waterproof structure 600 is made of rubber, a rubber mixture, silica gel, a silica gel mixture, silicone rubber, resin or a hybrid material. The hybrid material includes at least one of rubber, a rubber mixture, silica gel, a silica gel mixture, silicone rubber and resin.

It should be noted that the rubber mixture is a mixture with rubber as a main material. Various additives, fillers, or the like, may be contained in the rubber mixture as required, and the silica gel mixture may be understood with reference to the definition of the rubber mixture, which is not repeated herein. The hybrid material may be mixed with at least one of hybrid rubber, a rubber mixture, silica gel, a silica gel mixture, silicone rubber, and resin. Certainly, in some embodiments, the waterproof structure 600 may be made of a hybrid material as long as the hybrid material may achieve a required waterproof level, which is not limited in the embodiments of the present application. It can be understood that the materials mentioned above are all existing materials, composition of the waterproof structure 600 are not protected in the embodiments of the present application, and the above structure only utilizes characteristics of the existing materials to achieve the waterproof effect. Those skilled in the art can flexibly make selection among the existing materials based on the inventive concept of the embodiments of the present application.

In this way, according to different use requirements, different materials can be flexibly selected to make the waterproof structure 600, so as to meet corresponding waterproof requirements.

In some implementations, the waterproof structure 600 may be in the form of adhesive tape, an adhesive strip, or a sealant. Selection may be made according to specific use situations, and is not limited in the embodiments of the present application.

It should be noted that the photovoltaic module according to the embodiments of the present application may further include a frame, a junction box, or the like, and relevant setting may be made according to specific use conditions, which are not repeated herein.

In summary, in the embodiments of the present application, the waterproof structure 600 is sandwiched between the back sheet 100 and the front sheet 200, and the leading-out end 401 of the busbar 400 can extend out of the lead hole K via the waterproof structure 600, so that the situation that the water and moisture enter the photovoltaic module through the lead hole K can be improved. Meanwhile, the waterproof structure 600 is arranged in the photovoltaic module, so that the risk of the failure of the waterproof structure 600 cause by the waterproof structure 600 being arranged outside the photovoltaic module and easily subjected to the external stress may be reduced, and also, the waterproof structure 600 may be rigidly constrained by means of the lamination pressure of the photovoltaic module, and thus, the waterproof structure 600 is more firmly connected to the back sheet 100 and the front sheet 200. Further, the arrangement of the waterproof structure 600 suitable for a use situation may also be flexibly selected according to the implementations of the waterproof structure 600 illustrated in some of the embodiments. Thus, a water and moisture blocking capability of the module at the lead hole K is significantly improved, the reliability of the waterproof structure 600 can also be improved, and then, the impact on the output power of the photovoltaic module is reduced, stability of outdoor use of the photovoltaic module is improved, and the safety performance is improved.

The technical features of above-mentioned embodiments can be combined arbitrarily. In order to make the description concise, not all possible combinations of the technical features are described in embodiments. However, as long as there is no contradiction in the combination of these technical features, the combinations should be considered as falling within the scope of the specification.

The embodiments as described above only illustrate several implementations of the present application, and the descriptions thereof are relatively specific and detailed, but they should not be construed as limiting the scope of the present application. It should be understood by those of ordinary skill in the art that various modifications and improvements can be made without departing from the concept of the present application, and all fall within the protection scope of the present application. Therefore, the protection scope of the present application should be subject to the appended claims.

## Claims

1. A photovoltaic module, comprising:
a back sheet (100) and a front sheet (200) which are oppositely arranged;
a solar cell string (300) arranged between the back sheet (100) and the front sheet (200);
a busbar (400) electrically connected to the solar cell string (300); and
a waterproof structure (600) sandwiched between the back sheet (100) and the front sheet (200); the back sheet (100) being provided with a lead hole (K), the busbar (400) having a leading-out end (401), and the leading-out end (401) extending out of the lead hole (K) via the waterproof structure (600);
wherein an orthographic projection of the lead hole (K) on a reference plane is located within an outer contour of an orthographic projection of the waterproof structure (600) on the reference plane, and the reference plane is a plane parallel to a plane where the lead hole (K) is located.

2. The photovoltaic module according to claim 1, wherein an inner contour of the orthographic projection of the waterproof structure (600) on the reference plane is located outside the orthographic projection of the lead hole (K) on the reference plane.

3. The photovoltaic module according to claim 1, wherein an inner contour of the orthographic projection of the waterproof structure (600) on the reference plane coincides with an outer contour of the orthographic projection of the lead hole (K) on the reference plane.

4. The photovoltaic module according to claim 1, wherein at least a part of an inner contour of the orthographic projection of the waterproof structure (600) on the reference plane is located within the orthographic projection of the lead hole (K) on the reference plane.

5. The photovoltaic module according to any one of claims 2 to 4, wherein the inner contour of the orthographic projection of the waterproof structure (600) on the reference plane has a regular shape.

6. The photovoltaic module according to any one of claims 2 to 4, wherein the inner contour of the orthographic projection of the waterproof structure (600) on the reference plane has an irregular shape.

7. The photovoltaic module according to any one of claims 2 to 4, wherein the busbar (400) has a bent portion (402) located upstream of the leading-out end (401) in a leading-out direction;
in the leading-out direction, the bent portion (402) is located between the waterproof structure (600) and the lead hole (K).

8. The photovoltaic module according to any one of claims 2 to 4, wherein the busbar (400) has a bent portion (402) located upstream of the leading-out end (401) in a leading-out direction;
the bent portion (402) is located in the waterproof structure (600).

9. The photovoltaic module according to claim 1, wherein the orthographic projection of the lead hole (K) on the reference plane is located on the orthographic projection of the waterproof structure (600) on the reference plane.

10. The photovoltaic module according to claim 9, wherein the waterproof structure (600) has an exposed surface (m) exposed through the lead hole (K);
the leading-out end (401) extends out of the exposed surface (m).

11. The photovoltaic module according to any one of claims 1 to 10, wherein an outer contour of the orthographic projection of the waterproof structure (600) on the reference plane has a regular shape.

12. The photovoltaic module according to any one of claims 1 to 10, wherein an outer contour of the orthographic projection of the waterproof structure (600) on the reference plane has an irregular shape.

13. The photovoltaic module according to any one of claims 1 to 10, wherein the waterproof structure (600) is made of rubber, a rubber mixture, silica gel, a silica gel mixture, silicone rubber, resin or a hybrid material, and the hybrid material comprises at least one of rubber, a rubber mixture, silica gel, a silica gel mixture, silicone rubber and resin.

14. The photovoltaic module according to any one of claims 1 to 10, wherein the back sheet (100) is a glass sheet, a metal composite sheet, a composite polymer sheet containing a metal film layer, or a composite polymer sheet containing an inorganic non-metal film layer.

15. The photovoltaic module according to any one of claims 1 to 10, wherein the photovoltaic module further comprises a packaging adhesive film (500);
the solar cell string (300) is packaged in the packaging adhesive film (500), and the packaging adhesive film (500) is bonded between the back sheet (100) and the front sheet (200).
